# EUROPÄISCHE PATENTANMELDUNG

(11) **EP 1 593 973 A1**
(43) Veröffentlichungstag der Anmeldung: **09.11.2005**
(21) Anmeldenummer: 05007244.6
(22) Anmeldetag: 02.04.2005
(51) Int. Cl.: G01R 11/04, G01R 11/24, E05B 65/00, E05B 35/00, B25B 13/48

(54) **Werkzeug zur Montage eines Stromzählers**

(30) Priorität: 05.05.2004 DE 102004022124
(71) Anmelder: ABB PATENT GmbH, 68526 Ladenburg (DE)
(72) Erfinder: Fritsch, Klaus, Dipl.-Ing., 67126 Hochdorf-Assenheim (DE)
(74) Vertreter: Miller, Toivo

(57) **Zusammenfassung**

Die Erfindung betrifft ein Werkzeug (30) zur Montage eines Zählers, insbesondere eines elektronischen Haushaltszählers, auf einer Zählerplattform, die eine Trägerplatte (10) aufweist, auf der der Zähler aufgesetzt ist, mit innerhalb der Plattform angeordneten Kontaktstücken, die mit Zu- und Abgangsleitungen verbunden sind, sowie mit Brückenelementen, mit denen die Kontaktstücke miteinander verbindbar und voneinander trennbar sind, wobei an der Platte (11) Vorsprünge vorgesehen sind, die mit den Brücken formschlüssig verbunden sind, so dass bei Bewegung der Platte (11) sowohl der Zähler als auch die Brücken in unterschiedliche Stellungen verbringbar sind. Das Werkzeug (30) zur Betätigung der Platte (11) weist zwei an einem Quersteg (24) befestigte, in gleiche Richtung vorspringende, unterschiedlich lange Zapfen (22, 25) auf, von denen der kürzere (22) in der Trägerplatte (10) ortsfest um eine Führungsachse drehbar geführt ist und der längere (25) in die Platte (11) eingreift. Durch Drehen des Werkzeugs (30) um die Achse des kürzeren Zapfens (22) kann die Platte (11) verschoben werden.

## Beschreibung

Die Erfindung betrifft ein Werkzeug zur Montage eines Stromzählers nach dem Oberbegriff des Anspruches 1.

Aus der DE 100 52 998 A1 ist ein Adapter zur Aufnahme eines Stromzählers bekannt geworden, bei dem der Stromzähler auf eine Plattform aufgesetzt wird, indem der Zähler zunächst senkrecht zur Plattformebene und dann parallel zur Plattformebene verschoben wird. Dies erfolgt ohne Werkzeug. Damit der Zähler in der Betriebsstellung nicht herausgenommen werden kann, ist eine Plombierung vorgesehen, die den Zähler in der Verriegelungsstellung festhält. Es hat sich jedoch herausgestellt, dass es verhältnismäßig leicht ist, die Plombierung zu entfernen, so dass der Stromzähler dennoch unbefugt herausgenommen werden kann. Da innerhalb der Plattform Mittel vorgesehen sind, mit denen automatisch bei der Demontage eine Überbrückung der Zu- und Abgangsleitungen erreicht wird ist ein Stromdiebstahl möglich, weil, wie erwähnt, lediglich die Plombierung gelöst werden muss.

Aus der DE ...... (Mp.-Nr. 04/551) ist bekannt, die Plattform so auszugestalten, dass unterhalb der Trägerplatte eine verschiebbare Platte angeformt ist, die Brücken betätigt, mit denen die innerhalb der Plattform befindlichen, mit den Zugangs- und Abgangsleitungen verbundenen Kontaktstücke überbrückt bzw. getrennt werden, wobei die Bewegung der Platte mittels eines Werkzeuges bewirkt werden soll. Die Verwendung eines Werkzeugs hat jedenfalls den Vorteil, dass ohne dieses Werkzeug der Stromzähler nicht aus seiner Betriebsstellung heraus bewegt werden kann. Als Werkzeug soll ein schraubendreherartiges Sonderwerkzeug verwendet werden, welches einen Exzenter dreht, der die Platte in Bewegung versetzt. Darüber hinaus besteht auch die Möglichkeit einen einfachen Schraubendreher zu verwenden und mit diesem Schraubendreher den Stromzähler in seine Betriebsstellung und wieder zurück zu verschieben.

Aufgabe der Erfindung ist es, ein Werkzeug zu schaffen, das als Spezialwerkzeug ausgebildet und mit dem das Verschieben der Platte auf einfache Weise und ohne große Kraftaufwendung bewirkt werden kann.

Diese Aufgabe wird erfindungsgemäß durch die Merkmale des Anspruches 1 gelöst.

Erfindungsgemäß besitzt das Werkzeug zur Betätigung der Platte an einem Quersteg befestigte, in gleiche Richtung vorspringende, unterschiedlich lange Zapfen, von denen bei Benutzung der kürzere in der Trägerplatte ortsfest um eine Führungsachse geführt ist und der längere in die Platte eingreift, wobei durch Drehen des Werkzeuges um die Achse des kürzeren Zapfens die Platte hin- und herbewegbar ist.

Gemäß einer besonders vorteilhaften Erfindung ist mit der Platte ein um die Führungsachse drehbarer Exzenternocken gekuppelt, in den der längere Zapfen eingreift und mit Drehung des Exzenternockens um die Führungsachse die Platte verschiebt.

Dabei kann das Werkzeug einen parallel zum Quersteg verlaufenden Handgriff aufweisen, der mit dem Quersteg mittels einer Verbindungsstange, deren Mittelachse die Führungsachse bildet bzw. mit dieser fluchtet, verbunden ist.

Mit dieser Ausführung wird aufgrund des quer zur Führungsachse verlaufenden Handgriffes die erforderliche manuelle Kraft reduziert, im Vergleich zu einem Werkzeug, bei dem der Handgriff in der Achse der Führungsachse liegt, wie dies bei einem Schraubendreher der Fall ist. Da darüber hinaus die Krafteinwirkung nicht in der Führungsachse liegt, sondern außerhalb der Führungsachse, erhält man ein erhöhtes Drehmoment, mit dem auch der Kraftaufwand verringert wird.

Anhand der Zeichnung, in der zwei Ausführungsbeispiele der Erfindung dargestellt sind, sollen die Erfindung sowie weitere vorteilhafte Ausgestaltungen und Verbesserungen und weitere Vorteile näher erläutert und beschrieben werden.

### Es zeigen

- Fig. 1: eine Seitenansicht eines Werkzeugs,
- Fig. 2: eine Aufsicht auf eine Trägerplatte einer Zählerplattform und
- Fig. 3: eine Teilansicht der Platte.

Es sei hier Bezug genommen auf die DE ......(Mp.-Nr. 04/551), in der eine Plattform beschrieben ist, bei der unterhalb einer Trägerplatte der Plattform eine verschiebbare Platte vorgesehen ist, mit der ein elektronischer Haushaltszähler aus seiner Aufsetzstellung in seine Betriebsstellung und wieder zurück bewegt werden kann. Unterschiedlich zu der Ausgestaltung nach dieser Patentanmeldung ist die Ausführung eines Werkzeuges.

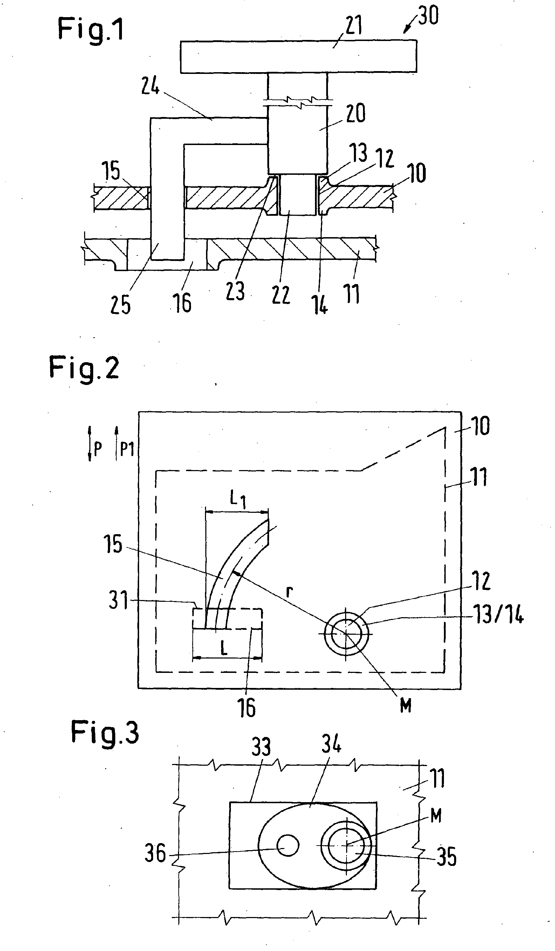

Die Fig. 1 zeigt eine Trägerplatte 10, unterhalb der eine verschiebbare Platte 11 angeformt ist, die hier nicht näher dargestellte Zapfen aufweist, mit denen Brücken verschoben werden, die zur Überbrückung von mit Zu- und Abgangsleitungen versehenen Kontaktstücken dienen. Auch hier wird diesbezüglich auf die genannte DE . (Mp.-Nr. 04/551) verwiesen.

Die Trägerplatte 10 besitzt eine Öffnung 12, die auf beiden Seiten der Platte mit ringförmigen Kragen 13, 14 im Bereich der Öffnung 12 verstärkt ist.

Weiterhin besitzt die Trägerplatte 10 einen kreisbogenförmigen Bogenschlitz 15. Der Mittelpunkt des mittleren Kreisbogens ist die Mittelachse M der Öffnung 12.

Die Platte 11 besitzt einen senkrecht zur Verschieberichtung der Platte, die mit dem Doppelpfeil P bezeichnet ist, verlaufende Aussparung 16, deren Länge L gleich oder größer als die auf eine Linie, die senkrecht zur Verschiebungsrichtung P verläuft, projizierte Länge L₁ ist.

Das Werkzeug, das in der Fig. 1 dargestellt ist, besitzt eine Basisstange 20, an dessen einem Ende eine als Handgriff dienende, quer verlaufende Handstange 21 befestigt ist; am anderen Ende besitzt die Stange 20 einen Zapfen 22, dessen Außendurchmesser dem Innendurchmesser der Öffnung 12 entspricht. Der Durchmesser der Stange 20 ist gegenüber den Durchmesser des Zapfens vergrößert, wobei eine Stufe 23 gebildet ist, mit der die Stange 20 auf der Leiste 13 aufliegt.

An der Stange 20 ist ein Quersteg 24 befestigt, an dem ein weiterer Zapfen 25 befestigt ist, wobei der weitere Zapfen 25 die Stirnebene des Zapfens 22 überragt. Wenn die Verbindungsstange 20 auf die Leiste 13 aufgesetzt wird, dann greift der Zapfen 22 lediglich in die Platte 10; der Zapfen 25 jedoch durchgreift den Bogenschlitz 15 und greift in den Schlitz 16 der Platte 11 ein.

Wenn nun das Werkzeug, das in seiner Gesamtheit die Bezugsziffer 30 besitzt, dann gleitet der Zapfen 25 in dem Bogenschlitz 15, wobei er gegen die in Bewegungsrichtung der Platte 11 vorne liegende Begrenzungskante 31 des Schlitzes 16 zum Anliegen kommt; dabei wird, wenn sich der Zapfen 25 in dem Bogenschlitz 15 bewegt, die Platte 11 und damit den Zähler in Pfeilrichtung P1 verschoben. Diese Drehbewegung erfolgt in der in der Fig. 2 dargestellten Ausführungsform im Uhrzeigersinn.

Wenn nun der Zähler aus der Betriebsstellung wieder herausgenommen werden soll, dann wird mittels des Werkzeuges 30 durch Drehen entgegen dem Uhrzeigersinn die Platte 11 mit dem Zähler wieder in die in der Fig. 2 dargestellte Stellung verschoben, wodurch der Zähler zum Herausnehmen freigegeben wird. Die Bogenlänge des Schlitzes 15 entspricht der Verschiebelänge der Platte.

Bei der Ausführung gemäß Fig. 3 befindet sich in der Platte 11 eine rechteckförmige Aussparung 33, in der ein um die Mittelachse M drehbarer Exzenternocken 34 angeordnet ist. Der Exzenternocken 34 ist drehbar um die Mittelachse M, und in einem dem Radius r entsprechenden Abstand (siehe Fig. 2) besitzt der Exzenternocken 34 eine Bohrung 36, in welche der Zapfen 25 bei der Montage und Demontage des Zählers eingreift. Die Öffnung 35 besitzt eine Mittelachse, die der Führungsachse M entspricht und über diese Öffnung 35 ist der Exzenternocken 34 drehbar ortsfest gelagert.

Bei einer anderen Ausführungsform könnten der Zapfen 25, der Quersteg 24 und der Zapfen 22 einstückig sein und in Verlängerung der Achse des Zapfens 22 würde eine der Stange 20 entsprechende Stange angreifen, deren Mittelachse der Führungsachse entspricht und mit dieser fluchtet bzw. mit dieser zusammenfällt; am Ende dieser Stange würde dann der Handgriff 21 befestigt sein.

## Patentansprüche

1. Werkzeug (30) zur Montage eines Zählers, insbesondere eines elektronischen Haushaltszählers, auf einer Zählerplattform, die eine Trägerplatte (10) aufweist, auf der der Zähler aufsetztbar ist, mit innerhalb der Plattform angeordneten Kontaktstücken, die mit Zu- und Abgangsleitungen verbunden sind und mit denen am Zähler angebrachte Kontaktfahnen in elektrisch leitende Verbindung gelangen, sowie mit Brückenelementen, mit denen die Kontaktstücke miteinander verbindbar und voneinander trennbar sind, wobei an der Platte (11) Vorsprünge vorgesehen sind, die mit den Brücken formschlüssig verbunden sind, so dass bei Bewegung der Platte (11) sowohl der Zähler als auch die Brücken in unterschiedliche Stellungen verbringbar sind, **dadurch gekennzeichnet, dass** das Werkzeug (30) zur Betätigung der Platte (11) zwei an einem Quersteg (24) befestigte, in gleiche Richtung vorspringende, unterschiedlich, lange Zapfen (22, 25) aufweist, von denen der kürzere in der Trägerplatte (10) ortsfest um eine Führungsachse drehbar geführt ist und der längere in die Platte (11) eingreift und das durch Drehen des Werkzeugs (30) um die Achse des kürzeren Zapfens (22) die Platte (11) hin- und herbewegbar ist.

2. Werkzeug (30) nach Anspruch 1, **dadurch gekennzeichnet, dass** mit der Platte (11) ein um die Führungsachse drehbarer Exzenternocken (34) gekuppelt ist, in den der längere Zapfen (25) eingreift und mit Drehung des Exzenternockens (34) um die Führungsachse die Platte (11) verschiebt.

3. Werkzeug (30) nach einem der vorherigen Ansprüche, **dadurch gekennzeichnet, dass** die Trägerplatte (10) einen bogenförmigen Schlitz (15, 31) aufweist, dessen Radius dem Abstand der beiden Zapfen (22, 25) und dessen Länge dem Verschiebeweg der Platte (11) entspricht.

4. Werkzeug (30) nach Anspruch 1, **dadurch gekennzeichnet, dass** die Platte (11) einen senkrecht zur Verschieberichtung verlaufenden Aufnahmeschlitz für den längeren Zapfen (25) aufweist, dessen Breite dem Außendurchmesser entspricht.

5. Werkzeug (30) nach einem der vorherigen Ansprüche, **dadurch gekennzeichnet, dass** es eine Stange aufweist, an deren einem Ende an ihrer Stirnfläche der kürzere Zapfen (22) angeformt ist, wobei der längere Zapfen (25) mittels eines Quersteges (24) an der Stange befestigt ist.

6. Werkzeug (30) nach einem der vorherigen Ansprüche, **dadurch gekennzeichnet, dass** um die Öffnung (12, 35) zur Aufnahme des kürzeren Zapfens (22) ein vorspringender Kragen (13, 14) vorgesehen ist, auf dessen die Stufung zwischen der Stange und dem Zapfen (22) mit geringerem Durchmesser aufliegt.

7. Werkzeug (30) nach einem der vorherigen Ansprüche, **dadurch gekennzeichnet, dass** der kürzere Zapfen (22) und der längere Zapfen (25) mittels des Quersteges (24) einstückig miteinander verbunden sind und dass eine Stange mit einem quer dazu angeordneten Handgriff in Verlängerung des kürzeren Zapfens (22) am Quersteg (24) befestigt ist.

8. Werkzeug (30) nach einem der vorherigen Ansprüche, **dadurch gekennzeichnet, dass** der Handgriff eine ebene Fläche aufweist, an der beispielsweise ein Logo aufdruckbar ist.
